Europäisches Patentamt

European Patent Office

Office européen des brevets

(10)

(11) Veröffentlichungsnummer: **0 242 779**
**B1**

(12) EUROPÄISCHE PATENTSCHRIFT

(45) Veröffentlichungstag der Patentschrift: **14.11.90**

(51) Int. Cl.⁵: **G 01 R 31/02,** G 01 R 31/00

(21) Anmeldenummer: **87105534.9**

(22) Anmeldetag: **14.04.87**

(54) Vorrichtung zur Identifikation eines freigeschalteten elektrischen Betriebsmittels.

(30) Priorität: **17.04.86 DE 3612894**

(43) Veröffentlichungstag der Anmeldung:
**28.10.87 Patentblatt 87/44**

(45) Bekanntmachung des Hinweises auf die
Patenterteilung:
**14.11.90 Patentblatt 90/46**

(84) Benannte Vertragsstaaten:
**CH DE FR LI SE**

(56) Entgegenhaltungen:
**AT-A- 357 634**
**US-A-4 095 212**
**US-A-4 491 785**

(73) Patentinhaber: **KGB Kernkraftwerke**
**Gundremmingen Betriebsgesellschaft mbH**
**Postfach 300**
**D-8871 Gundremmingen (DE)**

(72) Erfinder: **Reim, Walter, Dipl.-Ing. (FH)**
**Höhenweg 10**
**D-8871 Gundremmingen (DE)**

(74) Vertreter: **Andrejewski, Walter et al**
**Patentanwälte Andrejewski, Honke & Partner**
**Postfach 10 02 54 Theaterplatz 3**
**D-4300 Essen 1 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Beschreibung**

Die Erfindung betrifft eine Vorrichtung zur Identifikation eines freigeschalteten elektrischen Betriebsmittels, das über eine mehradrige Leitung mit elektrischer Energie versorgbar und mit Hilfe einer entfernt vom Betriebsmittel mit der Leitung in Reihe geschalteten Schalteinrichtung freischaltbar ist, wobei die Vorrichtung aus einem an zwei Adern der Leitung anzukoppelnden Sender und einem auf die Frequenz des Senders abgestimmten Empfänger besteht.

Elektrische Betriebsmittel, z. B. Elektromotoren, in Kraftwerken, insbesondere Kernkraftwerken, und Produktionsbetrieben müssen vor Durchführung von Instandhaltungsarbeiten freigeschaltet werden, wenn für das Instandhaltungspersonal die Gefahr der elektrischen Durchströmung oder der Schädigung durch anlaufende mechanische Teile besteht. Der Freischaltort, z. B. die Schaltanlage, ist in der Regel weit entfernt vom Arbeitsort, so daß das freigeschaltete Betriebsmittel nur durch die Bezeichnung vor Ort, z. B. durch ein Schild mit Anlagenkennzeichen, identifiziert werden kann. Verwechslungen beim Ausfüllen von Arbeitsaufträgen und Freischaltformularen oder beim Auffinden des Betriebsmittels können nicht ausgeschlossen werden. Zusätzliches Kurzschließen und Erden des elektrischen Betriebsmittels hat folgende Nachteile: Zusätzlicher Arbeits- und Zeitaufwand, Gefahr der Beschädigung der Klemmen und Zuleitungskabel, Gefahr der ungenügend durchgeführten Kurzschluß- und Erdverbindungen und Verwechslungsgefahr beim Wiederanklemmen der Leitungsphasen. Vergossene Kabelanschlüsse, wie sie z. B. bei Gau-festen oder Ex-geschützten Antrieben verwendet werden, können ohnehin nicht auf diese Weise gesichert werden.

Bei einer bekannten Vorrichtung der eingangs genannten Art (US—A—4 095 212) arbeiten Sender und Empfänger mit Funksignalen. Ist die Übertragungsstrecke zwischen Sender und Empfänger gestört, kann es zu folgenschweren Fehlern kommen.

Bekannt (US—A—4 491 785) ist auch eine Vorrichtung zur Identifikation eines über eine mehradrige Leitung mit Energie versorgbaren und mit Hilfe einer Schalteinrichtung freischaltbaren elektrischen Betriebsmittels aus einem an zwei Adern der Leitung anzukoppelnden Sender sich ändernder Frequenz und einem im Bereich des Betriebsmittels an die Leitung induktiv anzukoppelnden, auf die Frequenz des Senders abgestimmten Empfänger. Hierbei ist nachteilig, daß das dem Sender zugeordnete Ende der Leitung für den Anschluß des Senders offen zugänglich bzw. frei sein muß, was jedoch nicht immer zu verwirklichen ist.

Der Erfindung liegt die Aufgabe zugrunde eine Vorrichtung der eingangs genannten Art zu schaffen, die eine einwandfreie Identifikation eines freigeschalteten elektrischen Betriebsmittels gewährleistet.

Zur Lösung dieser Aufgabe ist die erfindungsgemäße Vorrichtung dadurch gekennzeichnet, daß der im Bereich der Schalteinrichtung zwischen dieser und dem kurzgeschlossenen Betriebsmittel an die Leitung anzukoppelnde Sender für das Senden und der im Bereich des Betriebsmittels an die Leitung induktiv anzukoppelnde Empfänger für das Empfangen einer vorgegebenen Folge von Blöcken zweier verschiedener im nieder frequenten Bereich liegender Frequenzen ausgelegt ist.

Bei Einsatz der erfindungsgemäßen Vorrichtung schaltet die elektrische Fachkraft das elektrische Betriebsmittel, z. B. einen Antrieb, in der Schaltanlage frei und sichert die Schalteinrichtung gegen Wiedereinschalten. Zwischen zwei Adern der abgehenden Leitung schließt die Fachkraft den Sender an. Die Instandhaltungstruppe begibt sich zum Arbeitsort und bringt den Empfänger an der Leitung unmittelbar vor dem Klemmkasten des Betriebsmittels an. Der Empfänger zeigt z. B. durch ein grünes Licht unverwechselbar an, daß der Arbeitsort freigeschaltet ist. Solange das Signal ansteht, hat das Instandhaltungspersonal die Sicherheit, daß der Freischaltzustand besteht. Die zwischen der Schalteinrichtung und dem Betriebsmittel verlegte Leitung dient bei der erfindungsgemäßen Vorrichtung mithin als Signalüberträger.

Für die weitere Ausgestaltung bestehen im Rahmen der Erfindung mehrere Möglichkeiten. So ist nach bevorzugter Ausführungsform der Sender für das Senden und der Empfänger für das Empfangen einer Folge von Blöcken der Frequenzen, 475 und 525 Hz ausgelegt. Außerdem empfiehlt sich für universelle Einsetzbarkeit der erfindungsgemäßen Vorrichtung, die Anordnung so zu treffen, daß der Sender und der Empfänger für eine Mehrzahl von verschiedenen Blockfolgen ausgelegt und mit jeweils einem Wahlschalter für eine bestimmte Blockfolge versehen sind. Zweckmäßigerweise ist der Empfänger über eine Spule, die mit Hilfe einer Zange an die Leitung ansetzbar ist, an eben diese Leitung ankoppelbar.

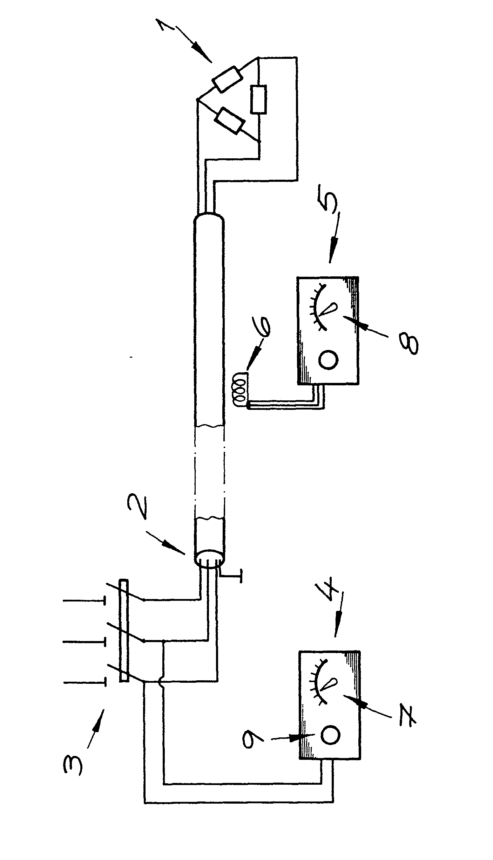

Im folgenden wird die Erfindung anhand einer Zeichnung näher erläutert, deren einzige Zeichnungsfigur schematisch eine Vorrichtung zur Identifikation eines freigeschalteten elektrischen Betriebsmittels in einem Kernkraftwerk zeigt.

Wie aus der Figur ohne weiteres ersichtlich ist, ist das aus einem Motor bestehende Betriebsmittel 1 über eine mehradrige Leitung 2 mit elektrischer Energie versorgbar und mit Hilfe einer entfernt vom Betriebsmittel 1 mit der Leitung in Reihe geschalteten Schalteinrichtung 3 freischaltbar. Die Vorrichtung besteht einerseits aus einem Sender 4 sich ändernder Niederfrequenz, der im Bereich der Schalteinrichtung 3 zwischen der Schalteinrichtung 3 und dem kurzgeschlossenen Betriebsmittel 1 an zwei Adern der Leitung 2 angekoppelt ist, und andererseits aus einem Empfänger 5, der im Bereich des Betriebsmittels 1 an die Leitung 2 induktiv angekoppelt ist und auf die Niederfrequenz des Senders 4 abgestimmt ist. Die induktive Ankopplung des Empfängers 5 erfolgt über eine Spule 6, die mit Hilfe einer Zange an die Leitung 2 ansetzbar ist. Der Sender 4 ist für das Senden und der Empfänger 5 für das Empfangen einer vorgegebenen Folge von Blöcken der Frequenzen 475 und 525 Hz ausgelegt. Diese Blockfolge kann aber geändert werden, d. h. der Sender und der Empfänger sind für eine Mehrzahl von verschiedenen Blockfolgen ausgelegt und mit jeweils einem Wahlschalter 7 bzw. 8 für eine bestimmte Blockfolge versehen. Im übringen bedarf der Aufbau des Senders 4 und des Empfängers 5 keiner näheren Erläuterung, da vergleichbare Schaltungen im Stand der Technik hinreichend bekannt sind.

Der Sender 7 wird also zwischen zwei Phasen der Leitung 2 unmittelbar hinter der Schalteinrichtung 3 angeklemmt. Er liefert einen konstanten Strom mit den Frequenzen 475 und 525 Hz, die nach einer vorgegebenen Blockfolge umgeschaltet werden. Die Blockfolge ist wie gesagt über den Wahlschalter 7 einstellbar. Zur Hin- und Rückleitung des Stromes werden die zwei Phasen der Leitung 2 verwendet, die zur Identifikation eingesetzt wird. Der Abschluß erfolgt im vorliegenden Fall über die Motorwicklung. Falls das elektrische Betriebsmittel 1 am anderen Ende beispielsweise eine Steckdose ist, so muß dort selbstverständlich ein Kürzschluß zwischen den einzelnen Phasen angebracht werden. Jedenfalls wird das ordnungsgemäße Funktionieren des Senders 7 mit einer grünen Leuchte 9 am Sender 7 signalisiert. Der Empfänger 5 erhält das codierte Signal des Senders 4 über die Spule 6, die mit der Zange an der Leitung 2 des elektrischen Betriebsmittels 1 angebracht ist. Am Empfänger 5 wird die vereinbarte Blockfolge mit dem Wahlschalter 8 eingestellt. Ist der Empfänger 5 eingeschaltet, so gibt ein Summer pulsartigen Alarm, wenn das Empfängersignal zu klein ist, die empfangene Blockfolge nicht mit der eingestellten Blockfolge übereinstimmt, länger als 1,8 Sekunden keine neuen Daten mehr empfangen werden und/oder die Versorgungsspannung zu klein ist.

**Patentansprüche**

1. Vorrichtung zur Identifikation eines freigeschalteten elektrischen Betriebsmittels (1), das über eine mehradrige Leitung (2) mit elektrischer Energie versorgbar und mit Hilfe einer entfernt vom Betriebsmittel (1) mit der Leitung (2) in Reihe geschalteten Schalteinrichtung (3) freischaltbar ist, wobei die Vorrichtung aus einem an zwei Adern der Leitung (2) anzukoppelnden Sender (4) und einem auf die Frequenz des Senders (4) abgestimmten Empfänger (5) besteht, dadurch gekennzeichnet, daß der im Bereich der Schalteinrichtung (3) zwischen dieser und dem kurzgeschlossenen Betriebsmittel (1) an die Leitung (2) anzukoppelnde Sender (4) für das Senden und der im Bereich des Betriebsmittels (1) an die Leitung (2) induktiv anzukoppelnde Empfänger (5) für das Empfangen einer vorgegebenen Folge von Blökken zweier verschiedener im nieder frequenten Bereich liegender Frequenzen ausgelegt ist.

2. Vorrichtung nach Anspruch 1, dadurch gekennzeichnet, daß der Sender (4) und der Empfänger (5) für eine Folge von Blöcken der Frequenzen 475 und 525 Hz ausgelegt ist.

3. Vorrichtung nach Anspruch 1 oder 2, dadurch gekennzeichnet, daß der Sender (4) und der Empfänger (5) für eine Mehrzahl von verschiedenen Blockfolgen ausgelegt und mit jeweils einem Wahlschalter (7 bzw. 8) für eine bestimmte Blockfolge versehen sind.

4. Vorrichtung nach einem der Ansprüche 1 bis 3, dadurch gekennzeichnet, daß der Empfänger (5) über eine Spule (6) die mit Hilfe einer Zange an die Leitung (2) ansetzbar ist, an die Leitung (2) ankoppelbar ist.

**Revendications**

1. Dispositif pour identifier un appareil électrique (1) déconnecté, qui peut être alimenté avec une énergie électrique par l'intermédiaire d'une ligne (2) à plusieurs conducteurs et être déconnecté à l'aide d'un dispositif de sectionnement (3) branché en série avec la ligne (2), dans une position éloignée de l'appareil (1), le dispositif étant constitué par un émetteur (4) devant être accouplé aux deux conducteurs de la ligne (2), et par un récepteur (5) réglé sur la fréquence de l'émetteur (4), caractérisé en ce que l'émetteur (4) devant être accouplé à la ligne (2), au niveau du dispositif de sectionnement (3) entre ce dernier et l'appareil (1) court-circuité, et que le récepteur (5), devant être accouplé de façon inductive à la ligne (2) au niveau de l'appareil (1) sont conçus respectivement pour l'émission et la réception d'une suite prédéterminée de blocs possédant deux fréquences différentes situées dans le domaine des basses fréquences.

2. Dispositif selon la revendication 1, caractérisé en ce que l'émetteur (4) et le récepteur (5) sont conçus pour une suite de blocs possédant les fréquences 475 et 525 Hz.

3. Dispositif selon la revendication 1 ou 2, caractérisé en ce que l'émetteur (4) et le récepteur (5) sont conçus pour une multiplicité de différentes suites de blocs et sont équipés d'un commutateur de sélection respectif (7 ou 8) pour une suite déterminée de blocs.

4. Dispositif selon l'une quelconque des revendications 1 à 3, caractérisé en ce que le récepteur (5) peut être accouplé à la ligne (2) par l'intermédiaire d'une bobine (6), qui peut être installée à l'aide d'une pince sur la ligne (2).

**Claims**

1. Apparatus for the identification of a cleared electrical device (1) to which electrical energy can be supplied via a multi-core cable (2) and which can be cleared by a switching means (3) connected in series with the cable (2) at a location remote from the device (1), the apparatus consisting of a transmitter (4) for coupling to two cores of the cable (2) and a receiver (5) tuned to the frequency of the transmitter (4), characterised in that the transmitter (4) for coupling to the cable (2) in the area of the switching means (3) between the latter and the short-circuited device (1) is designed for the transmission, and the receiver (5) for inductive coupling to the cable (2) in the area of the device (1) is designed for the reception of a predetermined sequence of blocks of two different frequencies in the low-frequency range.

2. Apparatus according to claim 1, characterised in that the transmitter (4) and the receiver (5) are designed for a sequence of blocks of the frequencies 475 and 525 Hz.

3. Apparatus according to claim 1 or 2, characterised in that the transmitter (4) and the receiver (5) are designed for a plurality of different block sequences and are each provided with a selector switch (7, 8) for a specific block sequence.

4. Apparatus according to any one of claims 1 to 3, characterised in that the receiver (5) is adapted to be coupled to the cable (2) via a coil (6) which can be attached to the cable (2) by means of a clip.